Europäisches Patentamt

European Patent Office

Office européen des brevets

(19)

(11) Veröffentlichungsnummer: **0 199 172**
**B1**

(12) **EUROPÄISCHE PATENTSCHRIFT**

(45) Veröffentlichungstag der Patentschrift:
14.02.90

(51) Int. Cl.⁴: **G01R 31/34**

(21) Anmeldenummer: **86104737.1**

(22) Anmeldetag: **07.04.86**

(54) **Einrichtung zum Erfassen einer unzureichenden oder ausgefallenen Erregung einer Synchronmaschine.**

(30) Priorität: **19.04.85 DE 3514285**

(43) Veröffentlichungstag der Anmeldung:
**29.10.86 Patentblatt 86/44**

(45) · Bekanntmachung des Hinweises auf die Patenterteilung:
**14.02.90 Patentblatt 90/7**

(84) Benannte Vertragsstaaten:
**AT BE CH DE FR GB IT LI LU NL SE**

(56) Entgegenhaltungen:
**CH-A- 442 490**
**US-A- 4 156 186**

**SIEMENS-ZEITSCHRIFT, Band 46, Nr. 12, 1972,**
**Seiten 912-915, Erlangen, DE; E. BORN et al.:**
**"Elektronischer Untererregungsschutz"**

(73) Patentinhaber: **Siemens Aktiengesellschaft,**
**Wittelsbacherplatz 2, D-8000 München 2(DE)**

(72) Erfinder: **Fischer, Armin, Dipl.-Ing., Ringstrasse 32a,**
**D-8525 Uttenreuth(DE)**

**Beschreibung**

Die Erfindung betrifft eine Einrichtung zum Erfassen einer unzureichenden oder ausgefallenen Erregung einer Synchronmaschine unter Auswertung von Ständerstrom und Ständerspannung in einer Meßschaltung.

Als Schutz gegen zu geringe Erregung oder gar Ausfall der Erregung einer Synchronmaschine sind aus der "Siemens-Zeitschrift", 1960, Heft 8, Seiten 634 bis 640 und 1972, Heft 12, Seiten 912 bis 915, Einrichtungen bekannt, die aus Ständerstrom und Ständerspannung eine Widerstands- oder Leitwertmessung durchführen. Die im untererregten Bereich der Synchronmaschine liegenden Auslösecharakteristiken dieser Einrichtung sind üblicherweise Kreise, Geraden, geknickte Geraden, Hyperbeln, Ellipsen u.a., deren Einstellwerte sich nach den für die Maschinenstabilität maßgebenden Impedanzwerten der Maschine, nämlich Synchronreaktanzen $X_d$ und $X_q$ sowie Transientreaktanzen $X'_d$ und $X'_q$ richten. Dabei können auch Vorimpedanzen von Netz und Transformator berücksichtigt werden.

Für die Bildung des benötigten Widerstands- oder Leitwertes werden dabei Strangstromwerte, Strangspannungswerte (z.B. $I_R$, $U_R$) bzw. verkettete Strom- und Spannungswerte (z.B. $I_{RS}$, $U_{RS}$) oder auch die Kombination von Strangwerten mit verketteten Werten (z.B. $I_R$, $U_{ST}$) verwendet.

Auf diese Weise ist bei symmetrischen Strom-Spannungszuständen an der Synchronmaschine die jeweils geforderte Auslösecharakteristik erreichbar, die ein Ansprechen der Einrichtung nur bei Untererregung bzw. Ausfall der Erregung bewirkt.

Dagegen kann bei unsymmetrischen Zuständen an der Synchronmaschine, wie sie z.B. bei Leiterunterbrechung oder unsymmetrischen Kurzschlüssen auftreten, trotz ausreichender Erregung ein Fehlansprechen der Einrichtung erfolgen.

Der Erfindung liegt die Aufgabe zugrunde eine Einrichtung der eingangs genannten Art zu schaffen, die sowohl bei symmetrischen als auch bei unsymmetrischen Strom-und/oder Spannungszuständen an der Synchronmaschine eine deren Untererregungszustand sicher erfassende Auslösecharakteristik aufweist, so daß bei unsymmetrischen Zuständen und ausreichender Erregung keine Fehlbetätigung der Einrichtung eintreten kann.

Eine einfache schnell arbeitende und sichere Lösung der gestellten Aufgabe gelingt nach der Erfindung dadurch, daß die Mitkomponenten von Ständerstrom und Ständerspannung als Meßgrößen der Meßschaltung zugeführt sind.

Dies gilt auch für den Fall, wenn statt der oben erwähnten Impedanz- bzw. Leitwertmessung eine Richtungsmessung oder Leistungsmessung zum Zwecke der Erfassung einer unzureichenden oder ausgefallenen Erregung angewandt wird.

Die Ausnutzung der Mitkomponenten erlaubt eine empfindliche Einstellung der Einrichtung unter Ausschluß von Fehlmessungen bei unsymmetrischen Zuständen.

Die Mitkomponente für eine Phase, z.B. Phase R ergibt sich zu

$$A_{1R} = \frac{1}{3}(A_R + A_S + a^2 A_T) \text{ mit } a = -0,5 + j\frac{\sqrt{3}}{2}$$
$$\text{und } a^2 = -0,5 - j\frac{\sqrt{3}}{2}$$

Die Mitkomponente $A_1$ kann dabei sowohl eine Strommitkomponente $I_{1R}$ als auch eine Spannungsmitkomponente $U_{1R}$ bzw. $I_{1S}$, $U_{1S}$ bzw. $I_{1T}$, $U_{1T}$ sein.

Zur Gewinnung der Mitkomponenten von Spannung und Strom sind in den betreffenden Pfaden jeweils bekannte Drehfeldscheider der Meßschaltung vorgeschaltet.

Die Einrichtung nach der Erfindung kann für den Schutz und/oder eine Untererregungsbegrenzungs-Regelung vorgesehen sein.

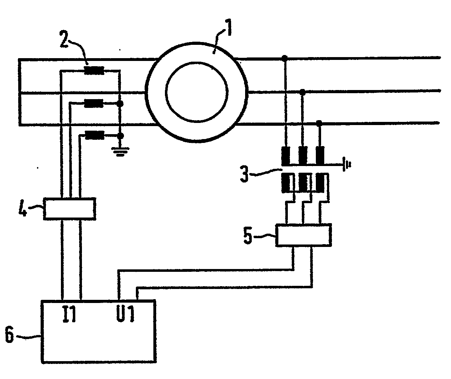

Ein stark vereinfachtes Schaltschema ist in der Zeichnung dargestellt.

Eine Synchronmaschine 1 arbeitet auf ein nicht dargestelltes Netz. In ihrem Ständerkreis sind in bekannter Weise Stromwandler 2 und Spannungswandler 3 angeordnet, die sekundärseitig jeweils über einen üblichen Drehfeldscheider 4 (für Strom) und 5 (für Spannung) auf die Meßschaltung 6 der Einrichtung geschaltet sind.

**Patentansprüche**

1) Einrichtung zum Erfassen einer unzureichenden oder ausgefallenen Erregung einer Synchronmaschine (1) unter Auswertung von Ständerstrom und Ständerspannung in einer Meßschaltung, dadurch gekennzeichnet, daß die Mitkomponenten von Ständerstrom und Ständerspannung als Meßgrößen der Meßschaltung (6) zugeführt sind.

2) Einrichtung nach Anspruch 1, dadurch gekennzeichnet, daß den Strom- und Spannungspfaden, die die Meßgrößen der Meßschaltung (6) zuführen, jeweils Drehfeldscheider (4, 5) vorgeschaltet sind.

**Claims**

1. Device for determining an insufficient or lost excitation of a synchronous machine (1) by evaluating stator current and stator voltage in a measurement circuit, characterised in that the positive sequence components of stator current and stator voltage are supplied as measured variables to the measurement circuit (6),

2. Device according to claim 1, characterised in that revolving field discriminators (4, 5) are respectively connected in front of the current and voltage paths which supply the measured variables to the measurement circuit (6).

**Revendications**

1. Dispositif pour détecter une excitation insuffisante ou défaillante d'une machine synchrone (1) moyennant l'évaluation du courant statorique et de la tension statorique dans un circuit de mesure, caractérisé en ce que les composantes directes du courant statorique et de la tension statorique sont envoyées, en tant que grandeurs de mesure, au circuit de mesure (6).

2. Dispositif suivant la revendication 1, caractérisé par le fait que des séparateurs respectifs de champ tournant (4, 5) sont branchés en amont des voies de courant et de tension, qui envoient les grandeurs de mesure au circuit de mesure (6).